# EUROPEAN PATENT APPLICATION

(11) **EP 2 110 460 A1**
(43) Date of publication of application: **21.10.2009**
(21) Application number: 09165523.3
(22) Date of filing: 28.12.2005
(51) Int. Cl.: C23C 16/40, C23C 28/04, C04B 41/52, C04B 41/50

(54) **Yttrium-containing ceramic coating**

(30) Priority: 28.12.2004 JP 2004379035; 21.01.2005 JP 2005014222; 16.03.2005 JP 2005074183
(62) Divisional of application: 05028578.2
(71) Applicant: Covalent Materials Corporation, Shinagawa-ku, Tokyo (JP)
(72) Inventor: Fijimori, Hiroyuki, Kanagawa 257-8566 (JP); Toya, Eiichi, Tokyo 141-0032 (JP); Nagahama, Toshio, Tokyo 141-0032 (JP); Yokoyama, Yuu, Kanagawa 257-8566 (JP)
(74) Representative: HOFFMANN EITLE

(57) **Abstract**

The present invention relates to an yttrium-containing ceramic coated material and a method of manufacturing the same. In the ceramic coated material of the invention, an amorphous yttrium-containing ceramic film having a thickness of 10 nm to 500 nm is formed on a substrate surface, a crystalline graded layer whose crystallinity increases gradually from the lower layer is formed on the amorphous yttrium-containing ceramic film, and further, a crystalline yttrium-containing ceramic film is formed on the crystalline graded layer.

## Description

### [Technical Field]

The present invention relates to a material coated with an yttrium-containing ceramic film, particularly to an yttrium-containing ceramic's coated material which is excellent in plasma resistance, corrosion resistance, etc., and can be suitably used as a part for a semiconductor fabrication machine, and to a method of manufacturing the same.

### [Background Art]

In a semiconductor manufacturing process, a treatment is carried out in a corrosive gas or plasma atmosphere that is represented by a wafer etching treatment. In an apparatus for such a plasma treatment, ceramics excellent in the corrosion resistance, such as quartz glass, high purity alumina, etc., are widely used.

However, even a part, which consist of the above-mentioned ceramics, are etched by being put under severe plasma environment. Thus, the part is damaged and degraded, which cause particle generation in a processing unit.

Recently, in order to address such a problem, it has been studied to use the ceramics, such as yttria and YAG that are materials excellent in plasma resistance.

However, yttria and YAG are difficult to form into a large product. A complicated shape is difficult even if it is a little product. When advanced technology is used, it becomes a considerably high cost.

Conventionally, for example, Japanese Laid-open Patent No. 2003-297809 (paragraphs 0013, 0014 etc.) discloses a part for a plasma etching apparatus in which a coating of yttria or YAG is formed on a surface of quartz glass substrate. As for this part, in order to prevent the coating from being peeled off, an edge of the substrate is rounded or means (such as unevenness provided on a substrate surface by way of a frosting treatment etc.) is used.

Further, Japanese Laid-open Patent No. 2004-281639 (paragraph 0040) discloses that a coating layer, such as YAG etc., which has a high plasma-etching resistance is formed by plasma spraying on a substrate made of an alumina sintered body.

### [DISCLOSURE OF THE INVENTION]

### [PROBLEMS TO BE SOLVED BY THE INVENTION]

However, in order to increase the adhesion of the coating, the part as disclosed in the above-mentioned Japanese Laid-open Patent No. 2003-297809 needs a process of changing the shape and surface quality of the substrate, resulting in a laborious task. Further, there is a problem in that particles are generated with these processes, and may cause contamination of a processing wafer by this part.

And even if a surface treatment is carried out for such a substrate, as mentioned above, part in the complicated shape is difficult to sufficiently prevent the coating from being peeled off.

Further, since the coating layer formed by plasma spraying as disclosed in the above-mentioned Japanese Laid-open Patent No. 2004-281639 is a crystalline layer or a mixed layer of crystal grains and amorphous part, it is not able to say that the coating layer is sufficient in peel-off resistance.

As mentioned above, the substrate and the coating are different in the quality of the material and thus different in thermal expansion coefficients. Even if it is possible to carry out the film formation, the coating may be peeled off, warp, cause cracks, etc., and it is difficult to obtain one that has durability also in the plasma treatment or high temperature processing.

The present invention is made to solve the above-mentioned technical problems and aims to provide an yttrium-containing ceramic coatedmaterial that is a material having a coating which is excellent in corrosion resistance to a corrosive gas, plasma, etc., that being excellent in adhesion between the substrate and the coating, and being suitably used for a semiconductor manufacturing process especially for repeated operations in a plasma treatment apparatus, and a method of manufacturing the same.

### [Means to Solve Problems]

An yttrium-containing ceramic's coated material of a first embodiment in accordance with the present invention is **characterized in that** an yttrium-containing ceramic film having an amorphous structure and a thickness of from 10 nm to 500 nm is formed on a substrate surface, and a crystalline yttrium-containing ceramic film is formed on the yttrium-containing ceramic film.

The yttrium-containing ceramic film is thus arranged to have a two-layer structure with the amorphous film and the crystalline film, so that the adhesion of the yttrium-containing ceramic film can be increased due to a thermal expansion relaxation effect by means of the amorphous film.

In the yttrium-containing ceramic's coated material of the above-mentioned first embodiment, it is preferable that the thickness of the crystalline yttrium-containing ceramic film is from 50 nm to 10 µm.

In terms of exerting characteristics, such as peel-off prevention of the yttrium-containing ceramic film, plasma resistance, etc., it is preferable that the crystalline yttrium-containing ceramic has the film thickness within the above-mentioned range.

Further, it is preferable that a crystalline graded layer whose crystalline increases gradually from the lower layer is formed between the above-mentioned amorphous yttrium-containing ceramic film and the above-mentioned crystalline yttrium-containing ceramic film.

The crystalline graded layer is thus formed as a middle layer, and the thermal expansion relaxation effect increases, so that the yttrium-containing ceramic film can be formed to have an increased total thickness and improve the plasma resistance, the corrosion resistance, etc.

In order to provide the yttrium-containing ceramic's coated material that has optical permeability, it is preferable that the above-mentioned yttrium-containing ceramic film is made of any of Y₂O₃, YAG, YN, and YOₓN_{y}. Further, it is preferable that the above-mentioned substrate is made of SiC or a SiC-Si compound material from a viewpoint of adhesion to the yttrium-containing ceramic film.

Further, a first method of manufacturing an yttrium-containing ceramic coated material in accordance with the present invention includes a first step of applying an yttrium MOD (Metal Organic Decomposition) coating agent to a substrate surface, performing a heat treatment so as to form an amorphous yttrium-containing ceramic film, and a second step of further applying the yttrium MOD coating agent on the above-mentioned amorphous yttrium-containing ceramic film, performing a heat treatment at a higher temperature than a temperature of the above-mentioned former heat treatment so as to form a more crystalline yttrium-containing ceramic film.

As mentioned above, by forming the yttrium-containing ceramic film by way of an MOD method, both the amorphous yttrium-containing ceramic film and the crystalline yttrium-containing ceramic film can easily be formed as a film with high adhesion.

In the above-mentioned manufacture method, by repeating the second step so as to form a plurality of films, and performing the heat treatment in a step of forming each film at a higher temperature than a temperature for an underneath film, the crystalline graded layer is preferably formed between the above-mentioned amorphous yttrium-containing ceramic film and the crystalline yttrium-containing ceramic film of the uppermost layer.

The heat treatment temperature is thus controlled, so that the middle layer having a crystalline graded structure can be formed. The yttrium-containing ceramic film is arranged to have a multilayer structure, so that a thicker film can be formed without causing the peel-off.

Further, an yttrium-containing ceramic's coated material of a second embodiment in accordance with the present invention is **characterized in that** a diamond-like carbon (Diamond Like Carbon; hereinafter abbreviated and referred to as DLC) film is formed on a substrate surface, and an yttrium-containing ceramic film is formed on the DLC film.

The DLC film is thus formed as the middle layer between the substrate and the yttrium-containing ceramic film, so that the adhesion of the yttrium-containing ceramic film can be increased by way of the thermal expansion relaxation effect by means of the DLC.

In the yttrium-containing ceramic's coated material of the above-mentioned second embodiment, it is preferable that the thickness of the DLC film is from 10 nm to 500 nm, and the thickness of the yttrium-containing ceramic film is from 50 nm to 20 µm.

It is preferable that the DLC film has the thickness within the above-mentioned range in terms of preventing the yttrium-containing ceramic film from being peeled off due to the difference in the coefficients of thermal expansion between the substrate and the upper yttrium-containing ceramics, and that the yttrium-containing ceramic film has the thickness within the above-mentioned range in terms of exerting the characteristics, such as the peel-off prevention, the plasma resistance, etc.

It is preferable that the above-mentioned DLC film has a graded structure in which sp³ bonds increase towards the above-mentioned yttrium-containing ceramic film. In this way the DLC film is formed so that the C (carbon) bonding state of DOC is arranged to be closer to the thermal expansion coefficients of both the substrate and the upper yttrium-containing ceramics, whereby the thermal expansion relaxation effect increases and the adhesion can be improved.

Further, an yttrium-containing ceramic coated material of a third embodiment in accordance with the present invention is **characterized in that** a composition graded film of DLC and an yttrium-containing ceramic is formed on a substrate surface, and the uppermost layer is an yttrium-containing ceramic film.

Thus, the adhesion of film can be more improved also by forming the film of composition containing DLC between the substrate and the yttrium-containing ceramic film.

Furthermore, an yttrium-containing ceramic coated material of a fourth embodiment in accordance with the present invention is **characterized in that** a plurality of layers are formed on a substrate surface such that DLC films and yttrium-containing ceramic films are alternately stacked.

Such a multilayer structure does not cause the yttrium-containing ceramic film to be peeled off, and allows its total thickness to be thick.

In the yttrium-containing ceramic's coated materials of the above-mentioned second through the fourth embodiments, it is preferable that amorphous structure films and crystalline films of thickness 10 nm to 500 nm stacked in order are the yttrium-containing ceramic's film. The yttrium-containing ceramic film is the two-layer structure with the amorphous film and the crystalline film, so that the adhesion of the yttrium-containing ceramic film can be increased due to the thermal expansion relaxation effect by means of the amorphous film.

It is preferable that the thickness of the above-mentioned crystalline yttrium-containing ceramic film is from 50 nm to 10 µm.

In terms of exerting the characteristics, such as the peel-off prevention of the yttrium-containing ceramic film and the plasma resistance, etc., it is preferable that the crystalline yttrium-containing ceramics has the film thickness within the above-mentioned range.

Further, it is preferable that the crystalline graded layer in which the crystalline increases gradually from the lower layer is formed between the above-mentioned amorphous yttrium-containing ceramic film and the above-mentioned crystalline yttrium-containing ceramic film.

The crystalline graded layer is thus formed as the middle layer, and the thermal expansion relaxation effect increases, so that the yttrium-containing ceramic film can be formed to have the increased total thickness and improve the plasma resistance, the corrosion resistance, etc.

As for the yttrium-containing ceramic coatedmaterials of the above-mentioned second through fourth embodiments, in terms of being durable against an environment at the time of DLC film formation, the adhesion of the DLC film, etc., it is preferable that the substrate is made of any of SiO₂, Al₂O₃, SiC, YAG, Y₂O₃, AlN, ZrO₂, ZnO and MgAl₂O₄ and C.

Further, it is preferable that the above-mentioned substrate is made of an optically permeable material, particularly made of any of SiO₂, Al₂O₃, SiC, YAG, and Y₂O₃. Thus, the yttrium-containing ceramic coated material in accordance with the present invention can be used also for a window material etc., and has an advantage that it can be an index of life of the coating material due to the reduction in the light transmittance as it degrades, and the judgment at the time of replacing.

Further, it is preferable that the above-mentioned yttrium-containing ceramic film is made of any of Y₂O₃, YAG, YN, and YOₓN_{y}, so as to be the yttrium-containing ceramic's coated material having the optical permeability, such as the window material, as mentioned above.

Further, a second method of manufacturing an yttrium-containing ceramic's coated material in accordance with the present invention includes a step of forming a DLC film on a substrate surface by way of plasma CVD (Chemical Vapor Deposition) method, and a step of forming an yttrium-containing ceramic film on the above-mentioned DLC film by way an MOD method. According to the plasma CVD method, the DLC film can be formed on the entire substrate surface in a short time, and the MOD method is comparatively simple as the film forming method for the yttrium-containing ceramic film. Further, according to a combination of these, the adhesion between the substrate and the yttrium-containing ceramic film can be more increased.

In the above-mentioned step of forming the DLC film by way of the plasma CVD method in the above-mentioned second manufacture method; it is preferable to form the DLC film while increasing the temperature from 200-400 °C to 250-800 °C.

By way of such temperature control, the DLC film in which the combined state of DLC has the graded structure can be formed.

Further, a third method of manufacturing an yttrium-containing ceramic coated material in accordance with the present invention includes a step of forming a compositionally graded film of DLC and an yttrium-containing ceramic on a substrate surface by way of a plasma CVD method, and a step of forming an yttrium-containing ceramic film by way of an MOD method on the above-mentioned composition graded film.

By way of the above-mentioned method, the compositionally graded film containing DLC can be formed between the substrate and the yttrium-containing ceramic film.

Further, a fourth method of manufacturing an yttrium-containing ceramic coated material in accordance with the present invention includes a step of forming a composition graded film of DLC and an yttrium-containing ceramic on a substrate surface, and a step of forming an yttrium-containing ceramic film by way of an MOD method on the above-mentioned composition graded film. In the step of forming the above-mentioned composition graded film, a plurality of layers are arranged to alternately stack the DLC films formed by way of a plasma CVD method and the yttrium-containing ceramic films formed by way of the MOD method, by changing the thicknesses so that the uppermost layer may be the yttrium-containing ceramic film and the upper yttrium-containing ceramic film may be thicker than the DLC film, then a heat treatment is carried out.

Thus, after the DLC films and the yttrium-containing ceramic films are arranged to be a multilayer structure where the film thicknesses are graded, the above-mentioned graded composite film that can also be formed by performing the heat treatment.

Furthermore, in the step of forming the above-mentioned composition graded film, instead of forming the DLC film by way of the plasma CVD method, the compositionally graded film by means of DLC can be formed by way of the above-mentioned heat treatment after the multilayer structure formation, even if a carbon polymer film is formed.

Further, a fifth method of manufacturing an yttrium-containing ceramic coated material in accordance with the present invention includes a step of carrying out ion implantation of carbon into a substrate surface, a step of forming a DLC film on the substrate surface by way of a plasma CVD method, a step of carrying out ion implantation of an yttrium-containing ceramic compound into the above-mentioned DLC film surface, and a step of forming an yttrium-containing ceramic film by way of an MOD method on the DLC film.

By performing such ion implantation processes, the adhesion between the substrate and the DLC film and between the DLC film and the yttrium-containing ceramic film can be further improved.

It is preferable that the step of forming the yttrium-containing ceramic film in the above-mentioned second through fifth manufacture methods is carrying out repeatedly a plurality of times.

The yttrium-containing ceramic film is arranged to be multi-layered, so that a thicker film can be formed without causing the peel-off.

Further, it is preferable that the above-mentioned step of forming the yttrium-containing ceramic film has a first step of applying an yttrium MOD coating agent, and performing a heat treatment so as to form an amorphous yttrium-containing ceramic film, and a second step of further applying the yttrium MOD coating agent on the above-mentioned amorphous yttrium-containing ceramic film, performing a heat treatment at a higher temperature than a temperature of the above-mentioned former heat treatment so as to form a more crystalline yttrium-containing ceramic film.

According to the above-mentioned MOD method, the yttrium-containing ceramic film has the two-layer structure with the amorphous film and the crystalline film, and both the films can easily be formed to have high adhesion.

Furthermore, by repeating the above-mentioned second step so as to form a plurality of films, and performing the heat treatment in the step of forming each film at a higher temperature than a temperature for an underneath film, the crystalline graded layer is preferably formed between the above-mentioned amorphous yttrium-containing ceramic film and the crystalline yttrium-containing ceramic film of the uppermost layer.

The heat treatment temperature is thus controlled, so that the middle layer having a crystalline graded structure can be formed. The yttrium-containing ceramic film is arranged to have a multilayer structure, so that a thicker film can be formed without causing the peel-off.

In the above-mentioned second through fifth methods of manufacturing the yttrium-containing ceramic coated material, after the step of forming the above-mentioned yttrium-containing ceramic film, the heat treatment step is preferably carried out so as to cause the temperature to rise and fall to 200 °C through 1250 °C at a rise-and-fall rate of temperature from 0.5 °C/min. to 5 °C/min.

With the heat treatment at gradually rising and falling temperatures after the film formation as mentioned above, the DLC film and the yttrium-containing ceramic film are inhibited from peeling off and thermal shock resistance can be improved.

### [Best Mode for Carrying Out the Invention]

Hereafter, the present invention will be described in detail.

In the yttrium-containing ceramic's coated material of the first embodiment in accordance with the present invention, the amorphous yttrium-containing ceramic film is formed on the substrate surface, and the crystalline yttrium-containing ceramic film is formed on the yttrium-containing ceramic film.

In other words, the yttrium-containing ceramic film formed on the substrate surface is arranged to have the two-layer structure with the amorphous film, and the crystalline film.

By forming the film in such a state, particularly interposing an amorphous layer between the substrate and the film made of the crystalline material, the thermal expansion relaxation of the upper and lower layers that differ in the quality of the material is achieved, and the adhesion of the yttrium-containing ceramic film can be improved.

In the yttrium-containing ceramic's coated material of the first embodiment, the above-mentioned substrate is not limited in particular, as far as it is a material that is durable against the environment at the time of the yttrium-containing ceramic film formation. A metal, glass, a ceramic, etc. are used generally. Among these, Si, SiO₂, Al₂O₃, SiC, YAG, Y₂O₃, AlN, ZrO₂, ZnO, MgAl₂O₄, C, etc. are used suitably.

Among these substrate materials, a substrate made of SiC or a SiC-Si compound material is excellent in the adhesion to the yttrium-containing ceramic film, thus being more preferable.

In addition, when using the yttrium-containing ceramic coated material of the above-mentioned first embodiment as the optically permeable part, the above-mentioned substrate needs to be constituted by an optically permeable material, so that SiO₂, Al₂O₃, SiC, YAG, Y₂O₃, etc. are used suitably. As long as they have optical permeability, they may be glass materials or may be ceramic materials.

The yttrium-containing ceramic's coated material where the yttrium-containing ceramic film of optical permeability is formed on such an optically permeable substrate can be used for the window material in a plasma apparatus etc. , for example.

Further, when it is used as a part for the plasma apparatus etc., since the light transmittance falls gradually due to degradation in repetition use, it also has an advantage that it can be an index of life of the part and the judgment at the time of replacing, for example.

Further, the above-mentioned yttrium-containing ceramic film is generally excellent in corrosion resistance and plasma resistance and its type is not limited. However, it is preferable that the above-mentioned yttrium-containing ceramic film is made of any of Y₂O₃, YAG, YN, and YOₓN_{y}, so as to be the above-mentioned yttrium-containing ceramic's coated material having the optical permeability.

Among the above-mentioned materials, it is particularly preferable that the substrate made of SiC or a SiC-Si compound material is combined with an yttria (Y₂O₃) film as the yttrium-containing ceramic film, in terms of the adhesion of film, the plasma resistance, the corrosion resistance, a molding process, the optical permeability, etc.

In the yttrium-containing ceramic coated material of the above-mentioned first embodiment, the amorphous yttrium-containing ceramic film plays the role of a thermal expansion relaxation layer between the substrate and an upper crystalline yttrium-containing ceramic film, and prevents the yttrium-containing ceramic film from being peeled off by a difference in the coefficients of thermal expansion between both the substrate and the upper crystalline yttrium-containing ceramic film.

From such a viewpoint, it is preferable that the thickness of the amorphous yttrium-containing ceramic film is from 10 nm to 500 nm.

When the above-mentioned thickness is less than 10 nm, the film thickness is too small and it is difficult to form the amorphous yttrium-containing ceramic film with an equal film thickness on the substrate surface. On the other hand, when the above-mentioned thickness exceeds 500 nm, there is a possibility that the yttrium-containing ceramic film may be peeled off.

The thickness of the above-mentioned amorphous yttrium-containing ceramic film is more preferably from 50 nm to 200 nm, and particularly preferably from 90 nm to 110 nm.

Further, the thickness of the crystalline yttrium-containing ceramic film formed on the above-mentioned amorphous yttrium-containing ceramic film is preferably from 50 nm to 10 µm.

When the above-mentioned thickness is less than 50 nm, there is a possibility that a sufficient effect may not be exerted as the yttrium-containing ceramic coated material. For this reason, the thicker the crystalline yttrium-containing ceramic film is, the more effects, such as plasma resistance, are acquired. However, when it exceeds 10 µm, it is difficult to cause the thermal expansion relaxation effect by means of the amorphous yttrium-containing ceramic film, as mentioned above.

It is more preferable that the thickness of the above-mentioned yttrium-containing ceramic film is from 200 nm to 1 µm.

The yttrium-containing ceramic coated material as mentioned above can be manufactured by way of the first manufacture method in accordance with the present invention, in particular the first step of applying the yttrium MOD coating agent to the substrate surface, performing the heat treatment so as to form the amorphous yttrium-containing ceramic film, and the second step of further applying the yttrium MOD coating agent on the above-mentioned amorphous yttrium-containing ceramic film, performing the heat treatment at the higher temperature than the temperature of the above-mentioned former heat treatment so as to form the more crystalline yttrium-containing ceramic film.

As mentioned above, by using the MOD method as the film formation of the yttrium-containing ceramic film, both the amorphous yttrium-containing ceramic film and the crystalline yttrium-containing ceramic film can easily be formed as the film with high adhesion.

For example, it is also possible to form an yttria film on the substrate surface made of SiC or Si-SiC compound material with adhesion power of 300 kg/cm² or more.

Here, by the MOD (Metal-Organic Decomposition) method is meant a type of film forming method in which an organic-metal solution, such as alcoholate, an alkoxide, etc., is applied, dried and gelated, then sintered by way of a heat treatment so as to be crystallized. In particular, techniques, such as a spin coat method and a dip coat method, can be used.

According to an MOD method, the yttrium-containing ceramic film can be formed with the heat treatment at a low temperature of about 400 °C in a state where the amorphous structure is maintained. Further, in order to form the more crystalline film, only the heat treatment temperature may be highly set at about 800 ° C, and the similar operation may only be repeated. Thus the yttrium-containing ceramic desired crystalline film can be formed relatively simply.

Further, in the yttrium-containing ceramic coated material of the first embodiment, in order to exert the thermal expansion relaxation effect by the above-mentioned yttrium-containing ceramic film, it is preferable that the crystalline graded layer in which the crystalline increases gradually from the lower layer to the upper layer is formed as the middle layer between the above-mentioned amorphous yttrium-containing ceramic film and the above-mentioned crystalline yttrium-containing ceramic film.

By making the yttrium-containing ceramic film into such a multilayer structure, it is possible to form the thicker film without causing the peel-off, thus improving the plasma resistance, the corrosion resistance, etc.

The crystalline graded layer as mentioned above can be formed by repeating a plurality of times the second step in the first manufacture method in accordance with the present invention so as to form the middle layer having a plurality of films, and performing the heat treatment in the step of forming each film of the middle layer at a higher temperature than that of the underneath film.

In the heat treatment in the MOD method, the lower the temperature for the film formation of the yttrium-containing ceramic film, the more amorphous structure. Conversely, the higher the temperature of the film formation, the more crystallized the structure. For this reason, the middle layer having the crystalline graded structure can be formed by controlling the heat treatment temperature so that the lower film of the middle layer may be formed at the low temperature and the upper film may be formed at the higher temperature.

The number of times of the repetition of the above-mentioned middle layer's formation process, i.e., the number of plies of the films in the middle layer, is not particularly limited. The crystalline graded layer may increase in crystalline either stepwise or continuously. In either state, the thicker film can be formed without causing the peel-off by making the crystalline into the graded structure where it is changed gradually.

In addition, the crystalline grade in the yttrium-containing ceramic film can be confirmed by way of TEM, EELS (Electron Energy-Loss Spectroscopy), etc.

Furthermore, by way of the method as mentioned above, after forming the yttrium-containing ceramic film formation on the substrate, the heat treatment step is preferably carried out so as to cause the temperature to rise and fall to 200 °C through 800 °C at a rise-and-fall rate of temperature from 0.5 °C/min. to 5 °C/min.

Further, in terms of promoting the film formation with higher homogeneity and higher adhesion over the whole film, retention time at the highest temperature in the above-mentioned heat treatment is preferably from 5 minutes to 3 hours and more preferably 30-60 minutes.

Distortion between layers is more relaxed by the heat treatment at gradually rising and falling temperatures after the film formation as mentioned above. Even if the obtained yttrium-containing ceramic coating part is used in a high temperature environment exceeding 400 °C, the yttrium-containing ceramic film is inhibited from being peeled off and the thermal shock resistance can be improved.

Further, the yttrium-containing ceramic coated material of the second embodiment in accordance with the present invention is one in which the DLC film is formed on the substrate surface, and the yttrium-containing ceramic film is formed on the DLC film.

In other words, the DLC film is formed as the middle layer between the substrate and the yttrium-containing ceramic film.

In particular, the DLC film which has the amorphous structure and is the thermal expansion relaxation layer of the upper and lower layers is interposed between the substrate and the film made of the material which has the crystalline, so that the adhesion of the yttrium-containing ceramic film can be improved, compared with the case where the yttrium-containing ceramic film is directly formed on the substrate.

Here, the DLC mean that it is a thin film constituted by carbon elements like a diamond or graphite and has the amorphous (non-crystal) structure, and its combined state has both a diamond structure (Sp³ bond) and a graphite structure (sp² bond). For this reason, physical properties of the DLC, such as the coefficient of thermal expansion, specific resistance, etc. are intermediate between those of diamond and graphite. Further, the DLC has optical permeability, and is very excellent in smoothness. It also has characteristics, such as a low coefficient of friction.

In the yttrium-containing ceramic's coated material of the second embodiment, the above-mentioned substrate is not limited in particular, as far as it is a material that is durable against the environment at the time of DLC film formation. A metal, glass, a ceramic, etc. are used generally. Among these, SiO₂, Al₂O₃, SiC, YAG, Y₂O₃, AlN, ZrO₂, ZnO, MgAl₂O₄, C, SiC-Si compound material, etc. are used suitably.

Among these substrate materials, SiC, SiO₂, and AlN that have a coefficient of thermal expansion relatively close to the coefficient of thermal expansion (2×10⁶ - 4×10⁶ /°C) of the DLC are more preferable since they are excellent in the adhesion to the DLC film.

In addition, when using the yttrium-containing ceramic coated material of the second embodiment as the optically permeable part, the above-mentioned substrate needs to be constituted by an optically permeable material, so that SiO₂, Al₂O₃, SiC, YAG, Y₂O₃, etc. are used suitably. As long as they have optical permeability, they may be glass materials or may be ceramic materials.

The above-mentioned optically permeable yttrium-containing ceramic coated material can be used for the window material in the plasma apparatus etc.

Further, when it is used as a part for the plasma apparatus etc. , since the light transmittance falls gradually due to degradation in repetition use, it also has an advantage that it can be the index of life of the part and the judgment at the time of replacing, for example.

In addition, the above-mentioned substrate surface does not need to be subjected to surface unevenness processing that is usually performed in order to increase the adhesion to the DLC film. Instead, the flat and smooth one may have higher adhesion power. When used as the above-mentioned optically permeable part, the surface of the above-mentioned substrate is more preferably caused to be a mirror plane in terms of securing the optical permeability.

Further, the yttrium-containing ceramic film formed on the above-mentioned DLC film is generally excellent in corrosion resistance and plasma resistance and its type is not limited. However, it is preferably made of any of Y₂O₃, YAG, YN, and YOₓN_{y}, so as to be the above-mentioned yttrium-containing ceramic's coated material having the optical permeability.

In the yttrium-containing ceramic coated material of the above-mentioned second embodiment, the DLC film plays the role of a thermal expansion relaxation layer between the substrate and an upper yttrium-containing ceramic film, and prevents the yttrium-containing ceramic film from being peeled off by a difference in the coefficients of thermal expansion between both the substrate and the upper crystalline yttrium-containing ceramic film.

From such a viewpoint, it is preferable that the thickness of the DLC film is from 10 nm to 500 nm.

When the thickness of the DLC film is less than 10 nm, the film thickness is too small and it is difficult to form it with an equal film thickness on the substrate surface. On the other hand, when the thickness of the DLC film exceeds 500 nm, there is a possibility that the DLC films may be peeled off and the light transmittance also falls by about 20 to 30 %.

The thickness of the above-mentioned DLC film is more preferably from 50 nm to 200 nm, and particularly preferably from 90 nm to 110 nm.

Further, the thickness of the above-mentioned yttrium-containing ceramic film is preferably from 50 nm to 20 µm. When the thickness of the yttrium-containing ceramic film is less than 50 nm, there is a possibility that a sufficient effect may not be exerted as the yttrium-containing ceramic coated material. For this reason, the thicker the yttrium-containing ceramic film is, the more effects, such as the plasma resistance, are acquired. However, when it exceeds 20 µm, it is difficult to cause the thermal expansion relaxation effect by means of the DLC film, as mentioned above.

It is more preferable that the thickness of the above-mentioned yttrium-containing ceramic film is from 1 µm 10 µm.

Further, it is preferable that the above-mentioned yttrium-containing ceramic film is arranged such that amorphous films having a thickness of from 10 nm to 500 nm and crystalline films are stacked in order.

The yttrium-containing ceramic film is thus arranged to have the two-layer structure with the amorphous film and the crystalline film, so that the thermal expansion relaxation of the upper and lower layers that differ in the quality of the material is achieved further, and the adhesion of the yttrium-containing ceramic film can be improved.

The above-mentioned amorphous yttrium-containing ceramic film plays the role of the thermal expansion relaxation layer between the lower layer DLC film and the upper crystalline yttrium-containing ceramic film.

From such a viewpoint, it is preferable that the thickness of the amorphous yttrium-containing ceramic film is from 10 nm to 500 nm. When the above-mentioned thickness is less than 10 nm, the film thickness is too small and it is difficult to form the amorphous yttrium-containing ceramic film with an equal film thickness on the substrate surface. On the other hand, when the above-mentioned thickness exceeds 500 nm, there is a possibility that the yttrium-containing ceramic film may be peeled off.

The thickness of the above-mentioned amorphous yttrium-containing ceramic film is more preferably from 50 nm to 200 nm, and particularly preferably from 90 nm to 110 nm.

Further, the thickness of the crystalline yttrium-containing ceramic film formed on the above-mentioned amorphous yttrium-containing ceramic film is preferably from 50 nm to 10 µm.

When the above-mentioned thickness is less than 50 nm, there is a possibility that a sufficient effect may not be exerted as the yttrium-containing ceramic coated material. For this reason, the thicker the crystalline yttrium-containing ceramic film is, the more effects, such as plasma resistance, are acquired. However, when it exceeds 10 µm, it is difficult to cause the thermal expansion relaxation effect by means of the amorphous yttrium-containing ceramic film, as mentioned above.

It is more preferable that the thickness of the above-mentioned yttrium-containing ceramic film is from 200 nm to 1 µm.

In addition, in the yttrium-containing ceramic coated material of the above-mentioned second embodiment, it is most preferred that the substrate is made from quartz, the yttrium-containing ceramic film is of the yttria (Y₂O₃) film, and the DLC film and a Y₂O₃ film have the thickness and structure as mentioned above, in terms of the plasma resistance, the corrosion resistance, the molding process, the optical permeability, etc.

The above-mentioned yttrium-containing ceramic coated material of the second embodiment can be manufactured via the second manufacture method in accordance with the present invention, i.e., the step of forming the DLC film on the substrate surface by way of the plasma CVD method, and the step of forming the yttrium-containing ceramic film on the above-mentioned DLC film by way of the MOD method.

The formation of the DLC film is generally performed by way of the plasma CVD method, PVD (Physical Vapor Deposition) methods, such as an ion-plating method, etc. Preferably it is, however, carried out by the plasma CVD method, since its film forming area is larger than that of the PVD method which needs to control a substrate surface temperature exactly and needs relatively complicated operations of the film forming process, it allows better mass-production, and the film can be formed on the entire substrate surface in a short time.

In the above-mentioned plasma CVD method, hydrocarbon gas (such as benzene gas, methane gas, acetylene gas, etc.) and hydrogen gas are introduced as a source gas into a vacuum chamber. In direct-current arc discharge plasma, the DLC film is formed on the substrate surface such that a hydrocarbon ion and an excited radical are generated and these ions and radicals collide with the substrate which is biased by a direct-current negative voltage so as to be solidified with energy according to the bias voltage. General film forming conditions are such that microwave electric power is 100-150 W, acetylene or methane concentration is 100 %, gas pressure is 5 - 20 Pa, and film forming velocity is 0.1 - 1 µm/min. for acetylene or 0.05 - 0.2 µm/min. for methane.

In addition, in the plasma CVD method, the substrate temperature in the film forming process is usually 150-250 °C that is a comparatively low temperature, since the substrate temperature rises by using no equilibrium plasma.

As described above, the DLC film formed by the methods as mentioned above has both the diamond structure (sp³ bond) and the graphite structure (sp² bond) in terms of a C combined state. It is in a state closer to the coefficients of thermal expansion of both the substrate and the upper yttrium-containing ceramic, so that the thermal expansion relaxation effect increases and the adhesion can be improved.

From such a viewpoint, the DLC film more preferably has the graded structure in which the substrate side and the yttrium-containing ceramic film side differ in the coefficients of thermal expansion and the sp³ bonds increase towards the yttrium-containing ceramic film that is on the DLC film.

It is preferable that the DLC film having the graded structure of the combined state as mentioned above is formed in the film forming step by way of the above-mentioned plasma CVD method, while increasing the temperature from 200-400 °C to 250-800 °C.

The lower the film formation temperature is, the closer is the DLC to a graphite-like amorphous structure where the sp² bonds are more abundant than the sp³ bond. Conversely, the higher the film formation temperature is, the closer is the DLC to the diamond structure where the sp³ bonds are more abundant than the sp² bonds. For this reason, the graded structure can be formed for the combined state of the DLC film by controlling the substrate surface temperature as mentioned above.

In addition, quantitative determination of the sp² bonds and the sp³ bonds in the DLC film can be confirmed by means of a combined spectrum by way of the EELS (Electron Energy-Loss Spectroscopy), RAMAN (Raman Spectroscopy) and XPS (X-ray Photoelectron Spectroscopy) etc.

Further, although the yttrium-containing ceramic film can be formed on the above-mentioned DLC film by way of the MOD method, the plasma CVD method, an atmospheric pressure CVD method, etc., it is preferable to carry out the film formation by way of the MOD method, in terms of being a comparatively simple method and matching with the CVD film formed by the above-mentioned plasma CVD method.

Although the yttrium-containing ceramic film formation by way of the above methods may be performed by one process, it is preferable to repeat it a plurality of times.

Thus, by arranging the yttrium-containing ceramic film to be a multilayer, it is possible to form a thicker film without causing the peel-off. As a result it is possible to prolong its life as a plasma-resistant part.

Further, in the above-mentioned process of forming the yttrium-containing ceramic film, the yttrium-containing ceramic film having the two-layer structure with the amorphous structure and the crystalline structure, as mentioned above, can be formed by way of the first step of applying the yttrium MOD coating agent, performing the heat treatment so as to form the amorphous yttrium-containing ceramic film, and the second step of further applying the yttrium MOD coating agent on the above-mentioned amorphous yttrium-containing ceramic film, performing the heat treatment at the higher temperature than the temperature of the above-mentioned heat treatment so as to form the more crystalline yttrium-containing ceramic film.

According to such an MOD method, the yttrium-containing ceramic film can be formed with the heat treatment at the low temperature of about 400 °C in the state where the amorphous structure is maintained. Further, in order to form the more crystalline film, only the heat treatment temperature may be highly set at about 800 °C - 1250 °C, and the similar operation may only be repeated. Thus the yttrium-containing ceramic film having a desired crystal can be formed relatively simply.

Furthermore, in the formation of the yttrium-containing ceramic film by way of the MOD method as mentioned above, the substrate surface may be one that is subjected to the mirror finishing process, or one that is formed into the rough surface by way of the water-resistant-paper polish etc., and it also has the advantage that the film can be directly formed with high adhesion regardless of its surface roughness.

Further, in the yttrium-containing ceramic coated material in accordance with the present invention, in order to exert the thermal expansion relaxation effect by the above-mentioned yttrium-containing ceramic film, it is preferable that the crystalline graded layer in which the crystalline increases gradually from the lower layer to the upper layer is formed as the middle layer between the above-mentioned amorphous yttrium-containing ceramic film and the above-mentioned crystalline yttrium-containing ceramic film.

By making the yttrium-containing ceramic film into such a multilayer structure, it is possible to form the thicker film without causing the peel-off, thus improving the plasma resistance, the corrosion resistance, etc.

The crystalline graded layers as mentioned above can be formed by repeating the second step in the step of forming the yttrium-containing ceramic film having the above-mentioned two-layer structure, the plurality of times, so as to form the middle layer made of the plurality of films, and performing the heat treatment in the step of forming of each film of this middle layer at the higher temperature than that of the underneath layer.

In the heat treatment in the MOD method, the lower the temperature of the film formation of the yttrium-containing ceramic film, the more amorphous structure. Conversely, the higher the temperature of the film formation, the more crystallized the structure. For this reason, the middle layer having the crystalline graded structure can be formed by controlling the heat treatment temperature so that the lower film of the middle layer may be formed at the low temperature and the upper film may be formed at the higher temperature.

The number of times of the repetition of the above-mentioned middle layer's formation process, i.e., the number of plies of the films in the middle layer, is not particularly limited. The crystalline graded layer may increase in crystalline either stepwise or continuously. In either state, the thicker film can be formed without causing the peel-off by making the crystalline into the graded structure where it is changed gradually.

In addition, the crystalline grade in the yttrium-containing ceramic film can be confirmed by way of TEM, EELS, etc.

Furthermore, in the fifth manufacture method in accordance with the present invention, the ion implantation of carbon is carried out to the substrate surface before forming the DLC film, and the ion implantation of the yttrium compound is carried out to the DLC film surface after the DLC film formation, then the yttrium-containing ceramic film may be formed.

By performing such ion implantation processing, the relaxation layers are respectively formed at an interface between the substrate and the DLC film and an interface between the DLC film and the yttrium-containing ceramic film, so that the adhesion between the substrate and the DLC film and between the DLC film and the yttrium-containing ceramic film may be further improved.

Further, although the above-mentioned yttrium-containing ceramic coated material is made of a three-layer structure in which the DLC film and the yttrium-containing ceramic film are formed on the substrate surface, it may be arranged such that the DLC films and the yttrium-containing ceramic films are alternately and repeatedly stacked further so as to form a plurality of layers, such as five layers, seven layers, nine layers, (the fourth embodiment).

By providing such a multilayer structure, as mentioned above, it is possible to form it with the increased total thickness without causing the yttrium-containing ceramic film to be peeled off, thus further improving the plasma resistance, the corrosion resistance, etc.

In the case of such a multilayer structure, as mentioned above, even if the DLC films formed on the yttrium-containing ceramic film is thinner than the DLC film formed on the substrate, the adhesion between the films is sufficient. In particular, each thickness of the DLC film is preferably from 1 nm to 50 nm.

As far as the thickness is within the above-mentioned range, it is possible to prevent each film from being peeled off. Even if the yttrium-containing ceramic film of the uppermost layer is corroded by etching etc. , and the DLC film in the lower layer is exposed, the DLC is instantaneously removed by plasma and becomes the same as the source gas, which does not cause particle contamination.

Further, the yttrium-containing ceramic's coated material of the third embodiment in accordance with the present invention may be arranged such that the compositionally graded film of the DLC and the yttrium-containing ceramic is formed on the substrate surface, and the uppermost layer is the yttrium-containing ceramic film.

In this case, the yttrium-containing ceramic by which the compositionally graded film is constituted employs the same type of material as that for the yttrium-containing ceramic film formed in the uppermost layer.

By forming the compositionally graded film, containing DLC, between the substrate and the yttrium-containing ceramic film in this way, the adhesion of the layer can also be improved

In addition, the compositionally graded structure of the DLC and the yttrium-containing ceramics in the above-mentioned compositionally graded film can be confirmed by way of TEM, EELS, etc.

In the plasma CVD method, the composition graded film can be continuously formed by changing the composition ratio of each source gas between the DLC and the yttrium-containing ceramics, so that the source gas of the yttrium-containing ceramic may increase (the third manufacture method).

As with the above-mentionedmethod, by way the MOD method, the yttrium-containing ceramic film is formed on the compositionally graded film formed as mentioned above.

Further, the formation of the above-mentioned compositionally graded film can also be carried out such that the DLC films formed by way of the plasma CVD method and the yttrium-containing ceramic films formed by the MCD method are alternately stacked to have the plurality of layers, by changing the thicknesses so that the uppermost layer may be the yttrium-containing ceramic film and the upper yttrium-containing ceramic film may be thicker than the DLC film, then carrying out the heat treatment (the fourth manufacture method) .

In particular, firstly, the DLC film with a thickness of 80 nm is formed on the substrate for example, and an yttrium-containing ceramic film with a thickness of 50 nm is formed on the DLC film. Next, a DLC film with a thickness of 60 nm is formed, and an yttrium-containing ceramic film with a thickness of 70 nm is formed on the DLC film, further a DLC film with a thickness of 40 nm is formed. An yttrium-containing ceramic film with a thickness of 90 nm is formed on the DLC film, furthermore a DLC film with a thickness of 20 nm is formed, and then an yttrium-containing ceramic film with a thickness of 1 - 10 µm is formed as the uppermost layer.

As mentioned above, the DLC films and the yttrium-containing ceramic films that are alternately stacked by changing the film thickness until the thickness of the yttrium-containing ceramic film is larger than the thickness of the DLC film. At this time, the uppermost layer is arranged to be an yttrium-containing ceramic film.

Thus, the compositionally graded layer is formed in the multilayer structure formed as mentioned above by way of solid phase reaction between respective films in a non-oxidizing gas atmosphere, such as argon, nitrogen, and hydrogen, by performing the heat treatment at a temperature of from 400 °C to 1250 °C.

In the step of forming the above-mentioned compositionally graded film, a carbon polymer film may be formed instead of stacking the DLC films.

As with the case of the DLC films, even the carbon polymer film can form the compositionally graded film by way of DLC via the heat treatment after forming the multilayer structure as mentioned above.

As an example of the above-mentioned carbon polymers, a phenol resin etc. is preferably used as one that is easy to form the DLC by way of the above-mentioned heat treatment.

Furthermore, by way of various methods as mentioned above, after the films made of DLC and yttrium-containing ceramics are formed on the substrate and the yttrium-containing ceramic film of the uppermost layer is formed, the heat treatment is preferably carried out so as to cause the temperature to rise and fall to 200 °C through 1250 °C at the rise-and-fall rate of temperature from 0.5 °C/min. to 5 °C/min.

Further, in terms of promoting the film formation with higher homogeneity and higher adhesion over the whole film, the retention time at the highest temperature in the above-mentioned heat treatment is preferably from 5 minutes to 3 hours and more preferably 30 - 60 minutes. The distortion between layers is more relaxed by the heat treatment at gradually rising and falling temperatures after the film formation as mentioned above. Even if the obtained yttrium-containing ceramic coating part is used in the high temperature environment exceeding 400 °C, the DLC film and the yttrium-containing ceramic film are inhibited from being peeled off and the thermal shock resistance can be improved.

As described above, the yttrium-containing ceramic coated material in accordance with the present invention is a material having a coating which is excellent in corrosion resistance to a corrosive gas, plasma, etc., being excellent in adhesion between the substrate and the coating, and being suitably used for a semiconductor manufacturing process especially for repeated operations in a plasma treatment apparatus, and can be arranged to be an optically permeable material.

Further, according to the manufacture method in accordance with the present invention, the yttrium-containing ceramic coated material having the excellent characteristics as mentioned above can be obtained suitably.

## Claims

1. An yttrium-containing ceramic coated material in which an amorphous yttrium-containing ceramic film having a thickness of from 10 nm to 500 nm is formed on a substrate surface, and a crystalline graded layer whose crystallinity increases gradually from the lower layer is formed on the amorphous yttrium-containing ceramic film, further, a crystalline yttrium-containing ceramic film is formed on the crystalline graded layer.

2. The yttrium-containing ceramic coated material as claimed in claim 1, wherein the thickness of said crystalline yttrium-containing ceramic film is from 50 nm to 10 µm.

3. A method of manufacturing an yttrium-containing ceramic coated material, comprising a first step of applying an yttrium MOD coating agent to a substrate surface, performing a heat treatment so as to form an amorphous yttrium-containing ceramic film, and a second step of further applying the yttrium MOD coating agent on said amorphous yttrium-containing ceramic film, performing a heat treatment at a higher temperature than a temperature of said former heat treatment so as to form a more crystalline yttrium-containing ceramic film,
wherein by repeating said second step so as to form a plurality of films, and performing the heat treatment in the step of forming each film at a higher temperature than a temperature for an underneath film, a crystalline graded layer is formed between said amorphous yttrium-containing ceramic film and the crystalline yttrium-containing ceramic film of the uppermost layer.
